# EUROPEAN PATENT APPLICATION

(11) **EP 2 541 512 A1**
(43) Date of publication of application: **02.01.2013**
(21) Application number: 11856352.7
(22) Date of filing: 19.09.2011
(51) Int. Cl.: G07F 15/00, G01R 1/30

(54) **INTELLIGENT ELECTRIC METER CENTRALIZED RECHARGING TERMINAL AND CONTROL METHOD THEREOF**

(30) Priority: 19.01.2011 CN 201110022072
(71) Applicant: Sichuan Electric Power Test & Research Institute, Chengdu, Sichuan 610071 (CN); State Grid Corporation of China, Beijing 100031 (CN)
(72) Inventor: LIU, Kun, Chengdu Sichuan 610071 (CN); ZHANG, Jiamin, Chengdu Sichuan 610071 (CN); TANG, Yong, Chengdu Sichuan 610071 (CN); BAI, Tai, Chengdu Sichuan 610071 (CN); YIN, Shanfeng, Chengdu Sichuan 610071 (CN); WANG, Shu, Chengdu Sichuan 610071 (CN)
(74) Representative: Klauer, Stephan
(86) International application number: PCT/CN2011/001590
(87) International publication number: WO 2012/097489

(57) **Abstract**

An intelligent electric meter centralized recharging terminal comprises an IC card interface circuit, an ESAM module circuit and two groups of RS485 communication module interface circuits. The IC card interface circuit is connected with a CPU via ICREST and ICIO data pins, the ESAM module circuit is connected with the CPU via data and reset pins SAMIO and SAMRST directly. The two groups of RS485 communication module interface circuits are respectively connected with the CPU, so as to realize communication with an intelligent electric meter and a collector, and monitor communication data between the collector and the electric meter in real time and forward the data. The IC card interface circuit completes communication with user card interfaces. The ESAM module circuit completes data exchange and reset operations and various safety certification operations such as encryption, decryption and operation. A program module for the intelligent electric meter centralized recharging terminal ensures the normal communications of the system.

## Description

### Technical Field

The invention relates to the technical field of the integration of electrical equipment and computer, in particular an intelligent electric meter centralized recharging terminal and control method thereof.

### Background Art

There are two existing methods to recharge an intelligent electric meter, the first method is to insert the electricity purchasing card into the intelligent meter to recharge; the other method is to remotely recharge via communication. The former intelligent electric meter through inserting the electricity purchasing card is called local fee control electric meter and is secure and reliable. However, if the electric meter is installed in the dark area and the place where the operation is not convenient, especially in tall buildings in modem cities, electric meters are installed in strong electric motor wells, it is very difficult for a user to perform the recharging operation. The later remote recharging is primarily aimed at remote recharged intelligent electric meters. Background data of power supplier are sent via GPRS to a concentrator; the concentrator then sends the data via the low-voltage power line carrier to a collector, finally the collector via RS485 to the operated intelligent electric meter. In this way, due to the complexity of the transmission path, once problems at one node emerge, operations of recharging management of many users' meters will be affected. Meanwhile, the reliability of low-voltage power line carrier and the success rate of one transmission are low, which causes that the user's electric meter cannot be recharged in time and the electricity supply cannot be restored. This brings the user much inconvenience to use electricity.

In order that a user may recharge his own electric meter conveniently, reliably and securely, and check the information of his electricity consumption in time, we combined the advantages of the above two methods and designed an intelligent electric meter centralized recharging terminal including the program module to control the intelligent electric meter recharging terminal. The intelligent electric meter centralized recharging terminal is connected directly via RS485 with many intelligent electric meters, which reduces intermediate transmission steps, greatly reduces transmission failures and improves the reliability of communication. Installation in the residential area or on the gate of a unit, solves the problem of the user's inconvenience to operate the recharging of his intelligent electric meter. The connected intelligent meters are charged by swiping card; meanwhile, the intelligent electric meter centralized terminal can also remind the user to buy credits and to recharge his meter in time to avoid a power cut. The user can also check his electricity information at any time using the keyboard or inserting his card.

The literature search illustrates that the document of Patent Application No. 201010283843.9 has disclosed "a control method of power equipment, the device and the associated system", which aims to be used to simultaneously modify the configuration of electrical equipment of many types. It includes the acquisition of the intelligent electric equipment type selected by the user; according to the selected intelligent power equipment type the corresponding equipment configuration template is then determined; according to the equipment configuration template a first configuration file is generated and is provided to the user; a second configuration file which is modified by the user is acquired; according to the second configuration file the communication protocol component is called; though the communication interface component that corresponds to the second configuration file, a network connection with the corresponding intelligent electric equipment is established and the second configuration file is sent to the equipment. However, the present invention's purpose, technical solution and characteristics are different from the above application.

### Content of the Invention

The aim of the present invention is to design an intelligent electric meter centralized recharging terminal including the control method to control the intelligent recharging terminal, in order to reduce intermediate transmission steps, transmission failures and to improve the reliability of communication; and to overcome the defects of both the local fee control electric meter and the remote recharge method; and to solve the problem of the user's inconvenience to operate the recharging of the intelligent electric meter. The technical solution to achieve the aim of the invention is:
An intelligent electric meter centralized recharging terminal comprises a CPU, a LCD display interface circuit connected to the corresponding port of the CPU, a keyboard circuit, a buzzer interface circuit, a memory circuit, as well as a power circuit that provides power supply for each circuit. It also comprises an IC card interface circuit, an ESAM module circuit and two groups of RS485 communication interface module circuits. The IC card interface circuit is connected to the CPU via ICREST, ICIO data and reset pins; the ESAM module circuit is connected directly to the CPU via data and reset pins SAMIO, SAMRST; the two groups of RS485 communication module interface circuits are connected to two groups of asynchronous serial communication ports, respectively; the CPU communicates with the intelligent electric meter and the collector via the two groups of asynchronous serial communication ports respectively. The IC card interface circuit completes the communication with the user card interface and sends the data information in the CPU; the ESAM module circuit completes data exchange and reset operations, encryption and decryption as well as various security certification operations.

The above described intelligent electric meter centralized recharging terminal further comprises a reset control circuit. The reset control circuit uses the power detection chip IMP809R and is connected to the MCLR pin of the CPU. If a power supply voltage lower than 2.63V is detected, the CPU will be reset.

The above described RS485 communication module interface circuit comprises RS485 interface chip. An optocoupler is placed between RS485 interface chip and the corresponding asynchronous serial communication port on the CPU.

The above described CPU chip uses PIC18F6621 or PIC18F6627.

The above described RS485 interface chip uses MAX1487.

In the group of RS485 communication module interface circuit that is used for the communication between the above described centralized recharging terminal and the intelligent electric meter, two thermistors are connected in series with A and B ends of the RS485 interface chip, respectively. A double-sided transient diode is placed between A and B ends.

The keyboard circuit of the intelligent electric meter centralized recharging terminal comprises three buttons, which achieve scroll up display, scroll down display, digital input and recharging confirmation of the LCD display interface circuit, respectively. The sound interface circuit comprises an active buzzer, which is connected to an IO port of the CPU. A transistor is placed between the buzzer and the CPU.

Comparing with the state-of-the-art, the advantages and beneficial effects of the invention include:
1. The design includes the IC card interface circuit and the ESAM module circuit. The IC card interface circuit completes the communication with user card interface. The user needs to simply insert the card, the information in the card will be sent into the CPU for operations; the ESAM module circuit completes data exchange and reset operations, encryption and decryption as well as various security certification operations. The security operations are all operated within the ESAM module circuit and have no relations with the CPU program, which guarantees the security of the system data.
2. The design includes two groups of RS485 communication module interface circuits, which achieve the communication with the intelligent electric meter and the collector respectively. This reduces intermediate transmission steps and transmission failures as well as improves the reliability of communication. Through the connection of the RS485 communication module interface circuit and the intelligent electric meter, and upwards through the connection of the RS485 communication module interface circuit and the collector, the communication data between the collector and the electric meter can be effectively monitored in real time and the data of the collector and the intelligent electric meter can be securely forwarded, which ensures the normal communications of the system. The RS485 communication module interface circuit and the CPU are electrically isolated through an optocoupler and hence run stably. The CPU can read the data of the intelligent electric meter in real time and display it via the LCD display interface circuit.
3. Though the reading process of the inserted user card, the credits in the card can be topped up into the user's own intelligent electric meter accurately and securely. Installation in the residential area or on the gate of a unit solves the problem of the user's inconvenience to operate the recharging of the intelligent electric meter. The connected intelligent meters can be recharged by swiping card. The user can also check his electricity consumption information at any time using the keyboard or inserting the card. The operations are easy, convenient, secure and reliable.

### Description of Drawings

Fig. 1 is a principle schematic block diagram of the hardware in the present invention.
Fig. 2 is a schematic of the installation and connection topology structure of the present invention.
Fig. 3 is a circuit diagram of the CPU in the present invention embodiment.
Fig. 4 is a circuit diagram of the reset control in the present invention embodiment.
Fig. 5 is a circuit diagram of the LCD display interface in the present invention embodiment.
Fig. 6 is a circuit diagram of the LCD power transformation in the present invention embodiment.
Fig. 7 is a circuit diagram of the keyboard interface in the present invention embodiment.
Fig. 8 is a circuit diagram of the buzzer interface in the present invention embodiment.
Fig. 9 is a circuit diagram of the RS485 communication module interface in the present invention embodiment.
Fig. 10 is circuit diagrams of the ESAM module and the power supply in the present invention embodiment.
Fig. 11 is a flowchart of the control method in the present invention.
Fig. 12 is a schematic diagram of the recharging operation in the present invention.

### Detailed embodiments

The present invention will be explained in more detail below, in conjunction with the appended drawings and exemplary embodiments.

### Embodiment 1:

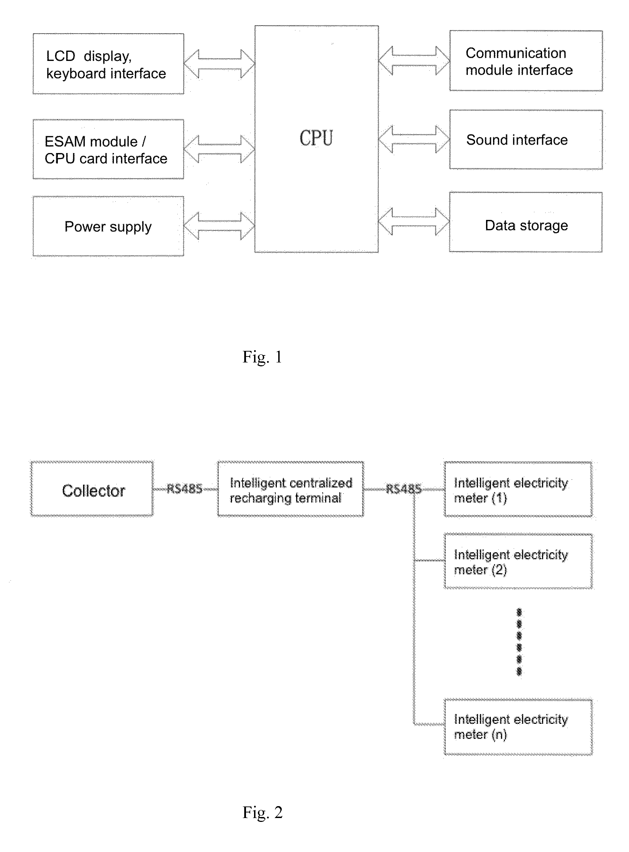

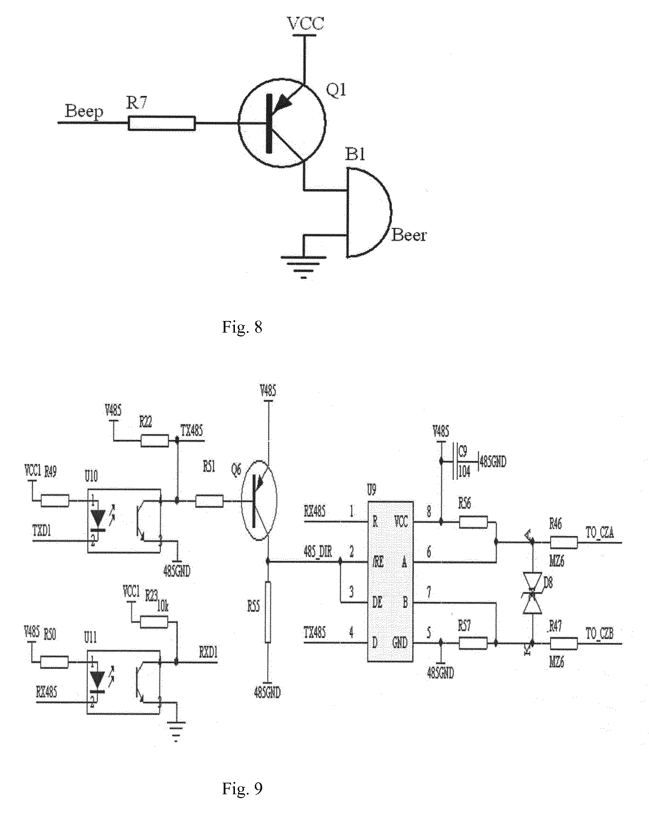

Referring to Fig. 1 to 11, the invention comprises the CPU, the LCD display interface circuit connected to the corresponding port of the CPU, the keyboard circuit, the sound interface circuit, the memory circuit, as well as the power circuit that provides power supply for each circuit. It also comprises the IC card interface circuit, the ESAM module circuit and two groups of RS485 communication module interface circuits. The IC card interface circuit completes the communication with the user card interface and sends the data into the CPU; the ESAM module circuit completes data exchange and reset operations, encryption and decryption as well as various security certification operations; the two groups of RS485 communication module interface circuits are connected to two groups of asynchronous serial communication ports of the CPU, respectively; the CPU communicates with the intelligent electric meter and the collector via the two groups of asynchronous serial communication ports respectively. For the connection of the present invention with the intelligent electric meter and the collector refer to Figure 2. The CPU is the key of the system function, a high-speed microcontroller with good anti-jamming capacity, programming space larger than 64kbytes, easy for C programming and with rich interface to facilitate functional expansion is chosen. In the present embodiment the CPU chip uses PIC18F6621.

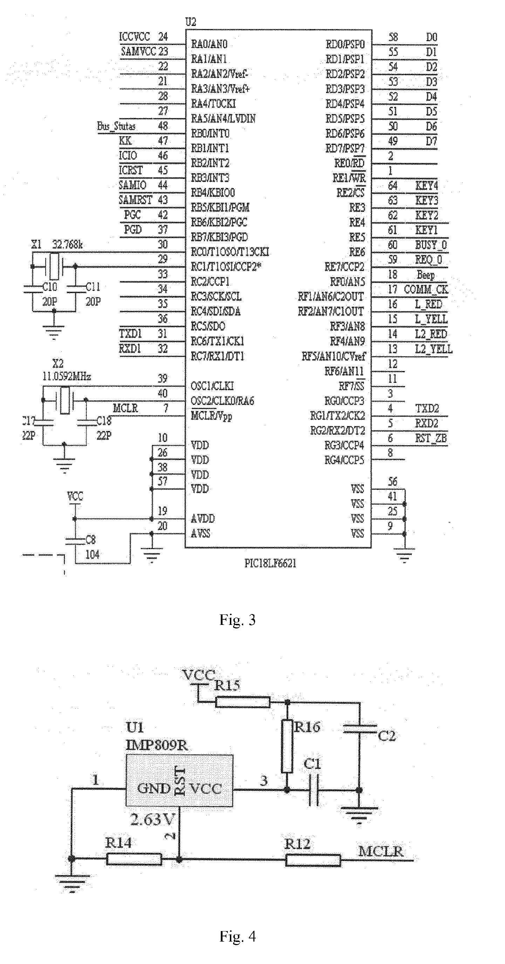

As shown in Fig. 3, the CPU selects an operating frequency 11.0592MHz, provides parallel outputs for the LCD display interface circuit, using the CPU's RDO ~ RD7 ports. Meanwhile, the control and busy judgment signal pins are provided, which completes the logic control of displaying the sent data; the ESAM module and IC card interface circuits with data lines, reset control lines, power lines and clock lines are provided, which guarantees the connection of the CPU with the ESAM module and IC card interface circuits to meet ISO7861 physical connection standard. Two independent USART interfaces, via RS485 isolation conversion, are used to communicate with the intelligent electric meter and the remote collector respectively. The connection between the CPU and the buzzer uses a control line; since an active buzzer is being used, the CPU is able to provide electric level to control the sound. We use the CPU internal E2 storage space for data storage.

IC card interface / ESAM circuits: IC card interface completes the communication with user card interface. Since we use the smart card, the design needs to meet ISO7816 relevant requirements. Meanwhile, an anti-attack protection circuit is arranged. The interface of the ESAM module is in consistent with the interface of the IC card.

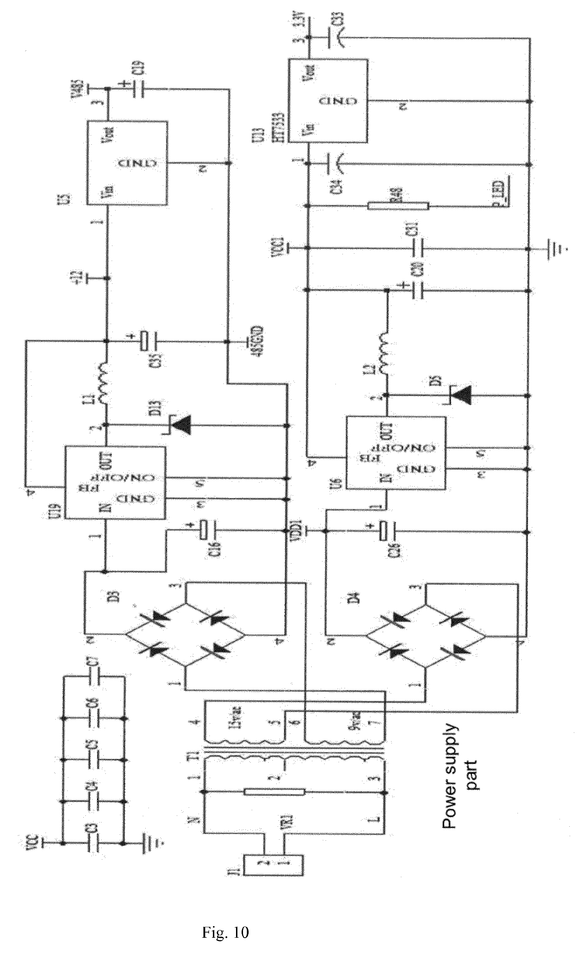

Referring to Fig. 10, the ESAM module interface circuit, wherein the data and reset pin SAMIO, SAMRST are connected directly with the CPU, completes data exchange and reset operations; MCUCLK is the working clock for the ESAM or the CPU card, with a frequency of 4MHz. The ESAM module completes encryption, decryption and various security certification operations; the key stored within the ESAM can not be read out; only the results of the operations can be obtained, meanwhile, the function of data storage is also included.

Referring to Fig. 4, the present invention further comprises a reset control circuit. The reset control circuit uses the power detection chip IMP809R, which is connected to the MCLR pin of the CPU. When a power supply voltage lower than 2.63V is detected, the CPU is reset, which ensures a normal booting of the CPU.

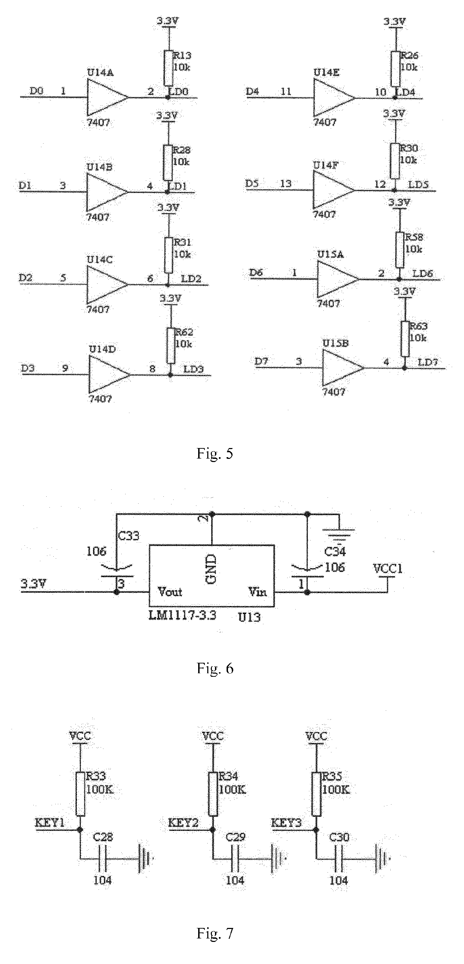

Referring to Fig. 5, the keyboard circuit comprises three buttons, KEY1, KEY2, KEY3, which achieve scroll up display, scroll down display, digital input and recharging confirmation of the LCD display interface circuit, respectively.

Referring to Fig. 6, the sound interface circuit comprises an active buzzer. The active buzzer is connected to an IO port of the CPU. Between the buzzer and the CPU a transistor Q1 is placed. Since the active buzzer is used, the CPU can control the sound of the buzzer by providing output of electric level: when the IO port connected with the buzzer is high electric level, the buzzer makes no sound; in contrast, at low electric level the buzzer makes sound.

Referring to Fig.7, RS485 communication module interface circuit comprises RS485 interface chip. An optocoupler is placed between RS485 interface chip and the corresponding asynchronous serial communication port on the CPU. The RS485 interface chip uses MAX1487; in the group of RS485 communication module interface circuit used for the communication with the intelligent electric meter, two thermistors, R46 and R47, are connected in series with A and B ends of the RS485 interface chip, respectively. A double-sided transient diode D8, placed between A and B ends, forms a protecting circuit in conjunction with thermistors R46 and R47, which prevents the RS485 interface chip damage through overvoltage and electrostatic shock.

Referring to Fig. 10, the system power design includes communication power supply DC12V and DC5V, main system power supply DC5V and display power supply DC3.3V, wherein the communication power is an isolation output. At the input end of the power supply, we have also designed a lighting protection circuit: through a varistor, inrush current is prevented from entering the system and disrupting its stability.

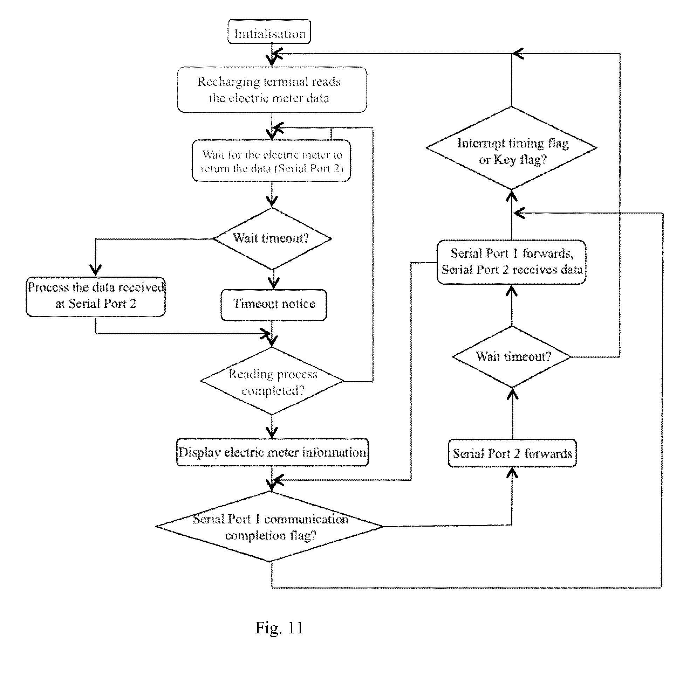

Refer to Fig.11 for the control method of the intelligent electric meter centralized recharging terminal, which includes the following steps:
(1) initialization; (2) the recharging terminal reads the electric meter data; (3) wait for the meter to return the data (referring to Serial Port 2); (4) judge whether a timeout occurs? If yes, timeout notice; if no, process the received data at Serial Port 2 and move to the next step; (5) judge whether the reading process has completed or not? If yes, display the information of the electric meter; if no, return to Step 3; (6) judge the flag that Serial Port 1 has completed the communication? If yes, move to the next step; if no, move to Step 9; (7) Serial Port 2 forwards; (8) judge whether a timeout occurs? If yes, return to Step 2; if no, move to the next step; (9) Serial Port 1 forwards the received data at Serial Port 2; (10) judge the interrupt timing flag or the button flag? If yes, return to Step 2; if no, return to Step 6.

The data sending and receiving in Serial Port 1 and Serial Port 2 are processed using interrupt query mode. The communication between the recharging terminal and electric meter uses RS485 with a bit-rate of 2400bps, with a carrier communication interface being reserved. The communication protocol meets DT/L645-2007 standard. When there is no recharge and query task, the recharging terminal and electric meters fetch data using polling mode, one cycle in every minute. In such a way, the data content of the electric meter is read in a loop.

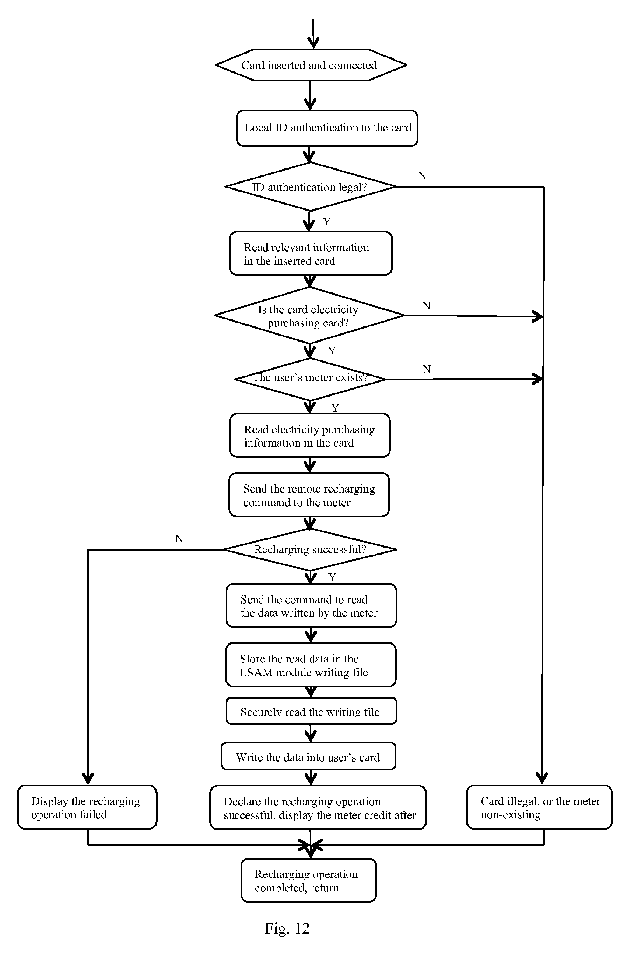

Fig. 12 is a schematic diagram of the recharging operation in the invention, which includes the following steps: (1) there is a card inserted and connected; (2) configure local ID authentication to the card; (3) judge whether the ID authentication is legal? If yes, move to the next step; if no, declare the card illegal, or the meter non-existing, move to the recharging operation complete step, return; (4) read relevant information of the inserted card; (5) judge whether the inserted card is electricity purchasing card? If yes, move to the next step; if no, declare the card illegal, or the meter non-existing, move to the recharging operation complete step, return; (6) read power purchasing information in the user card; (7) send the remote recharging operation command to the electric meter; (8) judge whether the returned recharging successful? If yes, send the command to read the data wrote by the meter; if no, display the recharging operation failed, move to the recharging operation complete step, return; (9) store the read data into the ESAM module writing file; (10) securely read the writing file; (11) write the data into the user's electricity purchasing card; (12) display the recharging operation successful and display new credit in the electric meter after recharging; (12) the recharging operation is complete, return.

### Embodiment 2:

The present CPU chip chooses PIC18F6627, remaining parts being the same as Embodiment 1.

Recharging operation process of the present invention is: in the idle state of the intelligent recharging terminal, the electricity information of each user's meter is displayed in a loop. Alternatively, the keyboard can be used to quickly scroll screen to check the display. When the terminal detects there is a user's electric meter that need to be reminded of recharging, the display will enter into the recharging remind interface, until no user needs to be reminded it will restart the normal display in idle loop. The user inserts the electricity purchasing card, after the intelligent recharging terminal judges that the inserted user card has met the legality requirements, it enters the user card query interface. When 'recharge' key is pressed, the intelligent centralized recharging terminal transmits the recharging amount and recharging times in the user card, in accordance to relevant security operation processes, via RS485 to the intelligent electric meter; the electric meter receives the data, checks legality and transmits the recharging result back to the intelligent centralized recharging terminal. Lastly, the intelligent centralized recharging terminal displays the recharging result: if the recharging is successful, it displays the recharged amount of this time and the electric meter counts the total amount; if the recharging is unsuccessful, it displays the recharging failed; meanwhile the buzzer sound indicates the recharging failed.

## Claims

1. An intelligent electric meter centralized recharging terminal, comprising a CPU, a LCD display interface circuit connected to the corresponding port of the CPU, a keyboard circuit, a sound interface circuit, a memory circuit, as well as a power supply circuit that provides power supply for each circuit, **characterised in that** it additionally comprises an IC card interface circuit, an ESAM module circuit and two groups of RS485 communication module interface circuits, wherein the IC card interface circuit is connected to the CPU via ICREST, ICIO data pin and reset pin, wherein the ESAM module circuit is connected directly to the CPU via data and reset pins SAMIO, SAMRST, wherein the two groups of RS485 communication module interface circuits are connected respectively to two groups of asynchronous serial communication ports of the CPU, wherein the CPU communicates through the two groups of asynchronous serial communication ports with the intelligent electric meter and the collector respectively.

2. The intelligent electric meter centralized recharging terminal according to claim 1, **characterised in that** it further comprises a reset control circuit, wherein the reset control circuit uses a power detection chip IMP809R and is connected to the MCLR pin of the CPU, in case of a power supply voltage lower than 2.63V being detected, the CPU will be controlled to be reset.

3. The intelligent electric meter centralized recharging terminal according to claim 1, **characterised in that** the RS485 communication module interface circuit comprises RS485 interface chip, with an optocoupler being placed between the RS485 interface chip and the corresponding asynchronous serial communication port on the CPU.

4. The intelligent electric meter recharging terminal according to claim 1, **characterized in that** the CPU chip uses PIC18F6621 or PIC18F6627.

5. The intelligent electric meter centralized recharging terminal according to claim 4, **characterised in that** the RS485 interface chip uses MAX1487.

6. The intelligent electric meter centralized recharging terminal according to claim 6, **characterised in that** in one group of RS485 communication module interface circuit used for the communication with the intelligent electric meter, two thermistors are connected in series with A and B ends of the RS485 interface chip, respectively, with a double-sided transient diode being placed between A end and B end.

7. The control method of the intelligent electric meter centralized recharging terminal according to claim 1, **characterised by** the following steps:
(1) initialization; (2) the recharging terminal reads the electric meter data; (3) wait for the electric meter to return the data (referring to Serial Port 2); (4) judge whether a timeout occurs? If yes, timeout notice; if no, process the received data at Serial Port 2 and move to the next step; (5) judge whether the reading is completed? If yes, display the information of the electric meter; if no, return to Step 3; (6) judge the flag that Serial Port 1 has completed the communication? If yes, move to the next step; if no, move to Step 9; (7) Serial Port 2 forwards; (8) judge whether a time-out occurs? If yes, return to Step 2; if no, move to the next step; (9) Serial Port 1 forwards the received data at Serial Port 2; (10) judge the interrupt timing flag or the button flag? If yes, return to Step 2; if no, return to Step 6.

8. The control method of the intelligent electric meter centralized recharging terminal according to claim 1, which is **characterised by** the following steps:
(1) there is a user card inserted and connected; (2) configure local ID authentication; (3) judge whether the ID authentication is legal? If yes, move to the next step; if no, declare the card illegal, or the meter non-existing, move to the recharging operation complete step, return; (4) read relevant information of the inserted card; (5) judge whether the card is electricity purchasing card? If yes, move to the next step; if no, display the card illegal, or the meter non-existing, move to the recharging operation complete step, return; (6) read electricity purchasing information in the user card; (7) send the remote recharging operation command to the electric meter; (8) judge whether the returned recharging successful? If yes, send the command to read the data wrote by the meter; if no, declare the recharging operation failed, move to the recharging operation complete step; (9) store the read data into the ESAM module writing file; (10) securely read the writing file; (11) write the data into the user's electricity purchasing card; (12) display the recharging operation successful and display new credit in the electric meter after recharging; (12) the recharging operation is complete, return.
